# EUROPEAN PATENT APPLICATION

(11) **EP 4 317 068 A1**
(43) Date of publication of application: **07.02.2024**
(21) Application number: 22780474.7
(22) Date of filing: 24.03.2022
(51) Int. Cl.: C01B 33/18, C08K 3/36, C08L 101/00, H01L 23/29, H01L 23/31

(54) **SPHERICAL INORGANIC POWDER AND LIQUID SEALING MATERIAL**

(30) Priority: 30.03.2021 JP 2021057562
(71) Applicant: Denka Company Limited, Tokyo 103-8338 (JP)
(72) Inventor: MINAMIKAWA, Takaaki, Tokyo 103-8338 (JP); YAMAMOTO, Akihiko, Tokyo 103-8338 (JP); FUKUDA, Takashi, Tokyo 103-8338 (JP)
(74) Representative: Murgitroyd & Company
(86) International application number: PCT/JP2022/013954
(87) International publication number: WO 2022/210260

(57) **Abstract**

[Problem] To provide an inorganic powder that can be used to obtain a resin composition with excellent flowability and that can prevent increases in aggregated particles in the resin composition.

[Solution] A spherical inorganic powder having, in a particle size frequency distribution, a first peak having a local maximum value in a particle size region from 0.1 µm or larger to 0.6 µm or smaller, and a second peak having a local maximum value in a particle size region from 1.5 µm or larger to 5.0 µm or smaller, wherein a value of a ratio of a frequency at the local maximum value of the second peak to a frequency at the local maximum value of the first peak is 1.5 or higher and lower than 10.0.

## Description

### TECHNICAL FIELD

The present invention relates to a spherical inorganic powder and a liquid encapsulation material.

### BACKGROUND

In recent years, semiconductor packages have become increasingly smaller, thinner, and higher in density in response to trends towards compactness/lightness and high performance in electronic devices. Additionally, the mounting methods thereof are coming to be dominated by surface mounting that is appropriate for high-density mounting on wiring boards, etc. As such advances are made in semiconductor packages and mounting methods thereof, there are demands for higher performance in semiconductor encapsulating materials, particularly in terms of functional improvements such as those in solder heat resistance, moisture resistance, low thermal expansion, mechanical properties, electrical insulation properties, etc. In order to satisfy these demands, resin compositions obtained by filling a resin with an inorganic powder of a metal oxide, etc., particularly an amorphous silica powder, are being used. The inorganic powders with which semiconductor encapsulating materials are filled preferably fill resins at a high rate in view of the solder heat resistance, the moisture resistance, low thermal expansion, and mechanical strength increase.

However, semiconductor encapsulating materials highly filled with an inorganic powder have problems in that, as the fill rate increases, the flowability becomes lower, making it more difficult for the materials to penetrate between a chip and a substrate, and thus making the productivity extremely poor. A method of adding a small amount of a fine powder or an ultrafine powder with a particle diameter smaller than 1 µm to a large-particle-diameter powder having a particle diameter on the order of tens of µm or to a medium-particle-diameter powder having a particle diameter on the order of a few µm in order to suppress decreases in flowability is known. Patent Document 1 describes a spherical inorganic powder having a maximum particle diameter of 6 µm or smaller, having a particle size frequency distribution exhibiting a local maximum diameter in at least the 1-3 µm particle size range, and having a ratio between the mode diameter and the median diameter, and a coefficient of variation in the particle size frequency distribution, that are respectively within prescribed ranges.

### CITATION LIST

### PATENT LITERATURE

Patent Document 1: JP 2003-221224 A

### SUMMARY OF INVENTION

### TECHNICAL PROBLEM

The particles in fine powders and ultrafine powders tend to aggregate when adjusting a semiconductor encapsulating material due to their extremely small particle diameters. Increases in aggregated particles can cause dispersion deficiencies. In such cases, the yield of the semiconductor encapsulating material can become poor, and semiconductor defects or short-circuits can occur in the final products.

A problem addressed by the present invention is to provide an inorganic powder that can prevent increases in aggregated particles in a resin composition.

### SOLUTION TO PROBLEM

The present inventors performed diligent research with the idea that reductions in flowability could be prevented while also preventing increases in aggregated particles by controlling the number and heights of peaks in a particle size frequency distribution diagram. The inventors surprisingly discovered that an inorganic powder having at least two peaks within a prescribed particle size region in a particle size frequency distribution diagram, wherein the value of the ratio between the frequencies at local maximum values of the two peaks is within a prescribed range, can reduce the aggregating properties in the resin composition while maintaining excellent flowability of the resin composition. The inorganic powder designed in this way is a novel powder that is unprecedented.
The present invention has the embodiments below.
[1] A spherical inorganic powder having, in a particle size frequency distribution, a first peak having a local maximum value in a particle size region from 0.1 µm or larger to 0.6 µm or smaller, and a second peak having a local maximum value in a particle size region from 1.5 µm or larger to 5.0 µm or smaller, wherein a value of a ratio of a frequency at the local maximum value of the second peak to a frequency at the local maximum value of the first peak is 1.5 or higher and lower than 10.0.
[2] The spherical inorganic powder according to [1] having, in the particle size frequency distribution, a local minimum value in a particle size region from 0.4 µm or larger to 1.0 µm or smaller.
[3] The spherical inorganic powder according to [2], wherein the ratio of the frequency at the local minimum value to the frequency at the local maximum value of the first peak is 0.9 or lower.
[4] The spherical inorganic powder according to any one of [1] to [3], wherein a ratio of a cumulative frequency of the second peak to a cumulative frequency of the first peak is 1.2 or higher.
[5] The spherical inorganic powder according to any one of [1] to [4] wherein, in the particle size frequency distribution, the cumulative frequency of particles having a particle diameter of 5.0 µm or larger is 1.2% or lower.
[6] The spherical inorganic powder according to any one of [1] to [5], wherein the spherical inorganic powder is silica, and a content of each of at least one component selected from the group consisting of iron oxide, sodium oxide, calcium oxide, magnesium oxide, and potassium oxide is 50 ppm or less.
[7] The spherical inorganic powder according to any one of [1] to [5], wherein the spherical inorganic powder is silica and the alumina content is 200 ppm or more and 1300 ppm or less.
[8] A liquid encapsulation material containing a resin and the spherical inorganic powder according to any one of [1] to [7].

### EFFECTS OF INVENTION

The present invention can provide an inorganic powder that can prevent increases in aggregated particles in a resin composition.

### DESCRIPTION OF EMBODIMENTS

Hereinafter, an embodiment of the present invention will be explained in detail. The present invention is not limited to the embodiment below, and can be implemented by adding modifications, as appropriate, within a range not compromising the effects of the present invention. In the present specification, the expression "X-Y", in connection with numerical ranges, means a range equal to or greater than X and equal to or less than Y.

### [Spherical inorganic powder]

The spherical inorganic powder according to the present embodiment (hereinafter also referred to simply as "inorganic powder") has, in a particle size frequency distribution, a first peak having a local maximum value in the particle size region from 0.1 µm or larger to 0.6 µm or smaller, and a second peak having a local maximum value in the particle size region from 1.5 µm or larger to 5.0 µm or smaller, wherein a value of a ratio of the frequency at the local maximum value of the second peak to the frequency at the local maximum value of the first peak is 1.5 or higher and lower than 10.0. By having at least two peaks within the above-mentioned prescribed particle size region in the particle size frequency distribution, wherein the value of the ratio between the frequencies at the local maximum values of the two peaks is within the above-mentioned prescribed range, increases in the aggregated particles in the resin composition can be prevented. Additionally, in the case in which the spherical inorganic powder is mixed with a large-particle-diameter inorganic powder having a particle diameter on the order of tens of µm to a medium-particle-diameter inorganic powder having a particle diameter on the order of a few µm, increases in aggregated particles in the resin composition can be prevented. The inorganic powder designed in this way is a novel inorganic powder that is unprecedented, and the characteristics of having at least two peaks in a prescribed particle size region and the value of the ratio between the frequencies at the local maximum values of the two peaks are extremely important factors in achieving both high flowability of the resin composition and low aggregating properties of the inorganic powder in the resin composition.

The spherical inorganic powder preferably has an average sphericity ((circularity)²), calculated from the circularity of individual particles automatically quantitatively measured by using a particle image analyzer, of preferably 0.85 or higher.

The "particle size frequency distribution" refers to the volume-based particle size frequency distribution. The "volume-based particle size frequency distribution" is measured by a laser diffraction/scattering method (refractive index: 1.50) and is represented by a distribution curve having the particle size (µm) on the horizontal axis and the volume-based frequency (%) on the vertical axis. The volume-based particle size distribution measured by a laser diffraction/scattering method (refractive index: 1.50) is measured by using a laser diffraction/scattering-type particle size distribution measuring apparatus ("LS-230" manufactured by Beckman-Coulter, Inc.), with water (refractive index: 1.33) as the solvent, and by performing a dispersion treatment by using an "Ultrasonic Disruptor UD-200 (equipped with an ultramicrotip TP-040)" manufactured by Tomy Seiko Co., Ltd. to apply a 200 W output for two minutes as a pretreatment.

The inorganic powder has a first peak and a second peak having local maximum values in a prescribed particle size region in the volume-based particle size frequency distribution. That is, the inorganic powder has at least two peaks, including the first peak and the second peak, in the volume-based particle size distribution. If there is a single peak, then increases in the aggregated particles in the resin composition cannot be prevented.

In this case, a "peak" refers to a peak-shaped curve having a boundary at which the slope of the curve changes from positive to negative in the volume-based particle size frequency distribution. The particle size at this boundary is referred to as a "local maximum value" (µm). In the present description, what is referred to as a "peak" does not include a shoulder (a portion in which there is a bulge or a step formed along the slope of the curve constituting a single peak). Although the respective peaks may have shoulders, the respective peaks preferably do not have shoulders for the purpose of filling the spaces between particles with a resin.

A single peak has a rising portion of a curve as a starting point, has a local maximum value (the vertex of the peak-shaped curve), and has an ending point at a point at which the frequency becomes zero or at a boundary at which the slope of the curve changes from negative to zero or positive.

The "first peak" refers to a peak having a local maximum value in the particle size region from 0.1 µm or larger to 0.6 µm or smaller in the volume-based particle size frequency distribution. The first peak has a local maximum value, in the volume-based particle size frequency distribution, preferably within the particle size region from 0.1 µm or larger to 0.5 µm or smaller, more preferably from 0.2 µm or larger to 0.5 µm or smaller, and even more preferably from 0.2 µm or larger to 0.4 µm or smaller.

The "second peak" refers to a peak having a local maximum value in the particle size region from 1.5 µm or larger to 5.0 µm or smaller in the volume-based particle size frequency distribution. The second peak has a local maximum value, in the volume-based particle size frequency distribution, preferably within the particle size region from 1.5 µm or larger to 4.0 µm or smaller, more preferably from 1.8 µm or larger to 3.5 µm or smaller, even more preferably from 1.8 µm or larger to 3.0 µm or smaller, and particularly preferably from 2.0 µm or larger to 2.7 µm or smaller.

The frequency at the local maximum value of the first peak is preferably 0.5-5.0%, more preferably 0.5-3.0%, even more preferably 0.5-2.8%, yet more preferably 0.7-2.7%, and particularly preferably 0.9-2.5%. By setting the frequency at the local maximum value of the first peak to be 0.5-5.0%, the value of the ratio of the frequency at the local maximum value of the second peak to the frequency at the local maximum value of the first peak can be easily adjusted to be within a prescribed range.

The frequency at the local maximum value of the second peak is preferably 3.5-9.0%, more preferably 4.0-8.5%, even more preferably 4.5-8.0%, and particularly preferably 4.8-7.6%. By setting the frequency at the local maximum value of the second peak to be 3.5-9.0%, the value of the ratio of the frequency at the local maximum value of the second peak to the frequency at the local maximum value of the first peak can be easily adjusted to be within the prescribed range.

The value of the ratio (frequency at local maximum value of second peak/frequency at local maximum value of first peak) of the frequency at the local maximum value of the second peak to the frequency at the local maximum value of the first peak is 1.5 or higher and lower than 10.0. In the case in which the value of the ratio of the frequency at the local maximum value of the second peak to the frequency at the local maximum value of the first peak is lower than 1.5 or 10.0 or higher, it is difficult to prevent increases in the aggregated particles in a resin composition. Additionally, the flowability of the resin composition can become lower.

The value of the ratio of the frequency at the local maximum value of the second peak to the frequency at the local maximum value of the first peak is preferably 1.7-9.5, more preferably 1.8-9.0, and even more preferably 1.9-8.4.

The cumulative frequency of the first peak is preferably 5.0-50.0%, more preferably 10.0-45.0%, and even more preferably 14.0-39.9%. By setting the cumulative frequency of the first peak to be 5.0-50.0%, the ratio of the cumulative frequency of the second peak to the cumulative frequency of the first peak, explained below, can be easily adjusted. The "cumulative frequency of the first peak" is the cumulative value of the frequency from the starting point to the ending point of the first peak.

The cumulative frequency of the second peak is preferably 50.0-95.0%, more preferably 55-90%, and even more preferably 60.1-86.0%. By setting the cumulative frequency of the second peak to be 50.0-95.0%, the ratio of the cumulative frequency of the second peak to the cumulative frequency of the first peak, explained below, can be easily adjusted. The "cumulative frequency of the second peak" is the cumulative value of the frequency from the starting point to the ending point of the second peak.

The ratio (cumulative frequency of second peak/cumulative frequency of first peak) of the cumulative frequency of the second peak to the cumulative frequency of the first peak is preferably 1.2 or higher, more preferably 1.3-7.0, and even more preferably 1.5-6.1. By setting the ratio of the cumulative frequency of the second peak to the cumulative frequency of the first peak to be 1.2 or higher, it is possible to easily achieve both high flowability of the resin composition and low aggregating properties of the inorganic powder in the resin composition.

The inorganic powder preferably has a local minimum value in the particle size region from 0.4 µm or larger to 1.0 µm or smaller in a volume-based particle size frequency distribution.

The inorganic powder may have a local minimum value, preferably in the particle size region from 0.5 µm or larger to 0.9 µm, and more preferably in the particle size region from 0.6 µm or larger to 0.8 µm or smaller in a volume-based particle size frequency distribution.

A "local minimum value" refers to the particle size in a valley portion between adjacent peaks in a volume-based particle size frequency distribution. A local minimum value may be a boundary at which the slope of the curve changes from negative to zero or positive. Thus, there is no local minimum value in the case in which there is only one peak in the volume-based particle size frequency distribution.

The frequency at the local minimum value is preferably 3.0% or lower, more preferably 0-2.5%, even more preferably 0-2.0%, and particularly preferably 0-1.7%.

The inorganic powder has a ratio (frequency at local minimum value/frequency at local maximum value of first peak) of the frequency at the local minimum value to the frequency at the local maximum value of the first peak of preferably 0.9 or lower, and more preferably 0-0.9.

The inorganic powder has a volume-based particle size frequency distribution such that the cumulative frequency of particles having a particle diameter that is 5.0 µm or larger is preferably 1.2% or lower, and more preferably 1.0% or lower.

The inorganic powder may have only the first peak and the second peak in the volume-based particle size frequency distribution, or may have one or more other peaks. The one or more other peaks may be present between the first peak and the second peak, may be present on the smaller-particle-diameter side of the first peak, or may be present on the larger-particle-diameter side of the second peak. When there are three or more peaks, it is sufficient for any two of the peaks to be within the range defined in the present embodiment.

In one embodiment, the first peak and the second peak may be adjacent to each other (i.e., there are no other peaks between the first peak and the second peak). In one embodiment, there may be one or more peaks present between the first peak and the second peak.

The method for adjusting the inorganic powder so that, in a particle size frequency distribution diagram, there are at least two peaks in the above-mentioned prescribed particle size region and so that the value of the ratio between the frequencies at the local maximum values of the two peaks is within the prescribed range can be performed by adjusting the flame temperature or the collection temperature at the time of production, as well as by the size of the raw material powder and classification.

### (Inorganic powder)

An example of an inorganic powder is a metal oxide powder. Examples of metal oxide powders include silica (SiO₂), alumina (Al₂O₃), titania (TiO₂), magnesia (MgO), calcia (CaO), etc. The inorganic powder should preferably include one or more metal oxide powders selected from the above, and should more preferably include silica. The inorganic powder is preferably a spherical inorganic powder, and is more preferably spherical silica. Amorphous silica produced by a method of melting crystalline silica at a high temperature is preferable for the purpose of bringing the thermal expansion coefficients of a semiconductor chip and the liquid encapsulation material close to each other, and from the viewpoint of the solder heat resistance, moisture resistance, and reducing the wear on dies.

Regarding the inorganic powder, the inorganic powder is silica, and the content of each of at least one component selected from the group consisting of iron oxide, sodium oxide, calcium oxide, magnesium oxide, and potassium oxide is preferably 50 ppm or less, more preferably 40 ppm or less, and may be 5-40 ppm.

Regarding the inorganic powder, the inorganic powder is silica, and the alumina content is preferably 200 ppm or higher and 1300 ppm or lower, more preferably 300 ppm or higher and 1000 ppm or lower, and even more preferably 400 ppm or higher and 700 ppm or lower. A spherical silica powder having an alumina content of 200 ppm or higher and 1300 ppm or lower can be produced by using an ore-derived raw material and is therefore advantageous in terms of cost.

The inorganic powder should preferably have a specific surface area, as measured by the BET method, of 15-24 m²/g from the viewpoint of further reducing the aggregating properties. The specific surface area measured by the BET method may be set to be 17-22 m²/g or 20-22 m²/g. The measurement of the specific surface area by the BET method can be performed by a specific surface area measuring device. For example, the measurement can be made by using a "Macsorb HM model-1208" (manufactured by Mountech Co., Ltd.).

### (Volume-based cumulative diameter)

The inorganic powder preferably has a volume-based cumulative 50% diameter D₅₀ of 1.2-2.8 µm. The "volume-based cumulative 50% diameter D₅₀" (also referred to as the "median diameter") is the particle diameter corresponding to a cumulative value of 50% in a volume-based cumulative particle size distribution measured by a laser diffraction/scattering method (refractive index: 1.50). The cumulative particle size distribution is represented by a distribution curve with the particle size (µm) on the horizontal axis and the cumulative value (%) on the vertical axis. The volume-based cumulative particle size distribution measured by a laser diffraction/scattering method (refractive index: 1.50) is measured by using a laser diffraction/scattering-type particle size distribution measuring apparatus ("LS-230" manufactured by Beckman-Coulter, Inc.), with water (refractive index: 1.33) as the solvent, and by performing a dispersion treatment by using an "Ultrasonic Disruptor UD-200 (equipped with an ultramicrotip TP-040)" manufactured by Tomy Seiko Co., Ltd. to apply a 200 W output for two minutes as a pretreatment.

The volume-based cumulative 50% diameter D₅₀ is 1.2-2.8 µm, more preferably 1.3-2.7 µm, even more preferably 1.3-2.6 µm, and particularly preferably 1.4-2.5 µm. In one embodiment, the volume-based cumulative 50% diameter D₅₀ is 1.5-2.5 µm.

The volume-based cumulative 50% diameter D₅₀ may be adjusted, for example, by adjusting the size of the raw material powder, or by classification. For example, the volume-based cumulative 50% diameter D₅₀ can be adjusted to a prescribed value by adjusting the particle diameter of the raw material powder, or by classifying (by sieve classification or by an air classifier) the powder after forming spheres.

The inorganic powder preferably has a volume-based cumulative 10% diameter D₁₀ of 0.1-0.3 µm, and more preferably 0.2-0.3 µm. By setting the volume-based cumulative 10% diameter D₁₀ to 0.1-0.3 µm, the particles can more easily enter into gaps between large-particle-diameter and medium-particle-diameter particles, thereby allowing the particles to be more densely packed. Additionally, aggregates can be reduced. Conversely, if D₁₀ is too small, then the flowability and the moldability tend to be degraded.

The inorganic powder preferably has a volume-based cumulative 25% diameter D₂₅ of 0.1-2.0 µm, more preferably 0.1-1.0 µm, and even more preferably 0.1-0.8 µm. By adjusting D₂₅, the number of particles included in a first peak can be optimized, thereby increasing the effects of the present invention. In one embodiment, the volume-based cumulative 25% diameter D₂₅ may be 0.4-1.7.

The inorganic powder preferably has a volume-based cumulative 90% diameter D₉₀ of 2.8-4.5 µm, more preferably 2.8-4.0 µm, and even more preferably 3.2-4.0 µm. By setting the volume-based cumulative 90% diameter D₉₀ to be 2.8-4.5 µm, the filling properties can be improved and the flowability can be significantly improved. In one embodiment, the volume-based cumulative 90% diameter D₉₀ may be 3.1-1.3.

The inorganic powder preferably has a volume-based cumulative 100% diameter D₁₀₀ of 6.0-8.5 µm, more preferably larger than 6.0 µm and 8.0 µm or smaller, and even more preferably 6.2-8.0 µm. By setting the volume-based cumulative 100% diameter D₁₀₀ to be 6.0-8.5 µm, more appropriate flowability can be obtained while filling the gaps between particles. In one embodiment, the volume-based cumulative 100% diameter D₁₀₀ may be 6.8-8.1.

The volume-based cumulative 10% diameter D₁₀, the volume-based cumulative 25% diameter D₂₅, the volume-based cumulative 90% diameter D₉₀, and the volume-based cumulative 100% diameter D₁₀₀ are the particle diameters at which the cumulative values are, respectively, 10%, 25%, 90%, or 100% in a volume-based cumulative particle size distribution measured by a laser diffraction/scattering particle size distribution measuring apparatus. The measurement method is the same as that for the volume-based cumulative 50% diameter D₅₀. The adjustment method is also the same as that for the volume-based cumulative 50% diameter D₅₀. That is, the volume-based cumulative 10% diameter D₁₀, the volume-based cumulative 25% diameter D₂₅, the volume-based cumulative 90% diameter D₉₀, and the volume-based cumulative 100% diameter D₁₀₀ can be adjusted to prescribed values by adjusting the particle diameter of the raw material powder, or by classifying (by sieve classification or by an air classifier) the powder after forming spheres.

### (Production method of inorganic powder)

An inorganic powder having the prescribed physical properties mentioned above can be produced, for example, by a method of pulverizing and classifying a commercially available ore, as needed, then supplying the powder to a high-temperature flame to form a fine spherical powder. This production method has, for example, the following steps:
(i) a step of pulverizing and classifying an ore, as needed, to obtain an ore powder (corresponding to an example of a raw material powder);
(ii) a step of supplying the ore powder to a high-temperature flame in a reaction vessel to form a fine spherical powder (melted powder); and
(iii) a step of classifying and collecting the fine spherical powder as needed.

### Step (i)

The ore used in step (i) is preferably a high-purity (for example, 95% or higher) ore. Examples of the ore include silica sand, silica stone, titanium ore, magnesium ore, calcium ore, etc. One or more types selected from the above are preferably used, and silica stone is more preferably included. An ore powder having a desired average particle diameter can be selected, as appropriate, by pulverizing the powder with a pulverizer such as a vibrating mill, a ball mill, etc.

The raw material powder has a particle diameter (volume-based cumulative 50% diameter D₅₀) of preferably 3.0-7.0 µm, and more preferably 4.5-5.5 µm. Multiple types of raw material powders having different particle diameters may be mixed together and used.

### Step (ii)

In step (ii), the ore powder obtained in step (i) is sprayed into a high-temperature flame formed by a flammable gas and a supporting gas using a burner, thereby melting and forming spheres from the ore powder at a temperature (for example, in the case of silica (silica stone), a temperature of 1800 °C or higher) equal to or higher than the melting point of the ore powder, and the powder is classified and collected while cooling to obtain a spherical powder (fine spherical powder). As the flammable gas, a hydrocarbon gas such as acetylene, ethylene, methane, ethane, propane, and butane; hydrogen; a gaseous fuel such as LPG or LNG; or a liquid fuel such as kerosene or heavy oil can be used. As the supporting gas, oxygen, an oxygen-rich cooling gas, or air can be used.

Additionally, the value of the ratio of the frequency at the local maximum value of the second peak to the frequency at the local maximum value of the first peak can be adjusted by adjusting the melting temperature. For example, by lowering the melting temperature, the value of the ratio of the frequency at the local maximum value of the second peak to the frequency at the local maximum value of the first peak can be made smaller. The melting temperature (flame temperature) is 1800-2200 °C, more preferably 1900-2100 °C, and even more preferably 1950-2100 °C.

The melting temperature can, for example, be adjusted by the gas amount or by the oxygen amount.

### Step (iii)

In step (iii), the fine spherical powder obtained in step (ii) is further classified and collected, as needed, by a cyclone, a sieving operation, etc. The value of the ratio of the frequency at the local maximum value of the second peak to the frequency at the local maximum value of the first peak can be adjusted by adjusting the powder collection temperature (the temperature of a bag filter when collecting the powder) at this time. For example, the value of the ratio of the frequency at the local maximum value of the second peak to the frequency at the local maximum value of the first peak becomes higher when the powder collection temperature is lowered.

The BET specific surface area can be adjusted by adjusting the powder collection temperature. For example, the BET specific surface area becomes larger when the powder collection temperature is lowered.

The powder collection temperature is preferably higher than 100 °C and lower than 300 °C, more preferably 120-290 °C, even more preferably 150-280 °C, and yet more preferably 170-250 °C.

### (Use)

The inorganic powder according to the present embodiment can be used in various applications. For example, it can be used to produce a material such as a semiconductor encapsulating material. In particular, it can be favorably used to produce a semiconductor encapsulating material for use in electronic devices because it can provide a resin composition with excellent flowability and can prevent the increase of aggregated particles in the resin composition.

### [Inorganic composition]

The inorganic composition according to the present embodiment includes the inorganic powder according to the above-described embodiment. Hereinafter, the inorganic powder according to the above-described embodiment will be referred to as "inorganic powder (P1)." The types and physical properties of the inorganic powder (P1) are described above, and therefore, the description will be omitted here. Since the inorganic powder (P1) is constituted by extremely fine particles, by forming an inorganic composition in which a small amount of this inorganic powder (P1) is added to a large-particle-diameter powder having a particle size on the order of tens of µm or to a medium-particle-diameter powder having a particle size on the order of a few µm, a resin composition having excellent flowability can be provided even in the case in which the resin is highly filled with (filled with a high content of) an inorganic substance. Additionally, the inorganic powder (P1) has at least two peaks within a prescribed particle size region in a particle size frequency distribution diagram, wherein the value of the ratio between the frequencies at local maximum values of the two peaks is within a prescribed range. Thus, increases in aggregated particles in the resin composition can be prevented.

In one embodiment, the inorganic composition may further contain an inorganic powder (P2) having a volume-based cumulative 50% diameter D₅₀ that is 10 µm or larger and 100 µm or smaller (preferably 20-80 µm, more preferably 30-70 µm) and/or an inorganic powder (P3) having a volume-based cumulative 50% diameter D₅₀ that is 3 µm or larger and smaller than 10 µm (preferably 3 µm or larger and 8 µm or smaller, more preferably 4 µm or larger and 6 µm or smaller). By including such a large-particle-diameter inorganic powder (P2) and/or a medium-particle-diameter inorganic powder (P3), the solder heat resistance, the moisture resistance, the low thermal expansion, and the mechanical strength of the resin composition can be improved.

The types (compound species) of the inorganic powder (P2) and the inorganic powder (P3) are not particularly limited, and they can be selected from among those indicated as examples of the inorganic powder (P1) in the above-described embodiment. The types of the inorganic powder (P2) and the inorganic powder (P3) may, independently of each other, be the same as or different from the inorganic powder (P1).

The inorganic powder (P1) content in the inorganic composition should preferably be 0.1-30 mass%, more preferably 1-20 mass%, and even more preferably 3-20 mass%. By setting the inorganic powder content in the resin composition to be 0.1-30 mass%, a resin composition having excellent flowability can be obtained even in the case in which a resin is highly filled with the inorganic composition.

The inorganic powder (P2) and/or the inorganic powder (P3) content in the inorganic composition should preferably be a total of 70-99.9 mass%, more preferably 80-99 mass%, and even more preferably 80-97 mass%.

### (Production method)

The production method of the inorganic composition is not particularly limited, and the inorganic composition can be obtained by mixing together each of the inorganic powders as a dry blend or the like using a known apparatus.

### (Use)

The inorganic composition according to the present embodiment can be used in various applications. For example, it can be used to produce a material such as a semiconductor encapsulating material. In particular, it can be favorably used to produce a semiconductor encapsulating material for use in electronic devices because it can provide a resin composition with excellent flowability and can prevent the increase of aggregated particles in the resin composition.

[Resin composition (liquid encapsulation material)] The resin composition according to the present embodiment includes a resin and the inorganic powder (P1) described above. The resin composition includes the inorganic powder (P1), and therefore has excellent flowability even in the case in which the resin is highly filled with an inorganic substance. The types and physical properties of the inorganic powder (P1) have been described above. Therefore, descriptions thereof will be omitted.

The inorganic powder (P1) content in the resin composition should preferably be 0.1-30 mass%, more preferably 1-20 mass%, and even more preferably 3-17 mass%. By setting the inorganic powder content in the inorganic composition to be 0.1-30 mass%, a resin composition having excellent flowability can be obtained even in the case in which a resin is highly filled with an inorganic substance.

In one embodiment, the resin composition further includes the inorganic powder (P2) and/or the inorganic powder (P3) described above. The types and physical properties of the inorganic powder (P2) and the inorganic powder (P3) have been described above. Therefore, descriptions thereof will be omitted.

The inorganic powder (P2) and/or the inorganic powder (P3) content in the resin composition should preferably be a total of 65-95 mass%, more preferably 70-90 mass%, and even more preferably 70-87 mass%. By setting the total content of the inorganic powders (P1)-(P3) in the resin composition to be 65-95 mass%, the resin is highly filled. Thus, the solder heat resistance, the moisture resistance, the low thermal expansion, and the mechanical strength of the resin composition can be improved.

### (Resin)

As resins, there are, for example, epoxy resins; silicone resins; phenol resins; melamine resins; urea resins; unsaturated polyesters; fluororesins; polyimides such as polyimide, polyamideimide and polyetherimide; polyesters such as polybutylene terephthalate and polyethylene terephthalate; polyphenylene sulfides; fully aromatic polyesters; polysulfones; liquid crystal polymers; polyethersulfones; polycarbonates; maleimide-modified resins; ABS resins, AAS (acrylonitrile-acrylic rubber/styrene) resins, AES (acrylonitrile/ethylene/propylene/diene rubber-styrene) resins, etc. The resin preferably includes at least one type selected from the above, and more preferably includes an epoxy resin.

The epoxy resins are not particularly limited, and for example, include phenol novolac-type epoxy resins, ortho-cresol novolac-type epoxy resins, phenol and aldehyde novolac resins that have been epoxylated, glycidyl ethers such as bisphenol A, bisphenol F, and bisphenol S, glycidyl ester acid epoxy resins obtained by reactions between epochlorohydrin and a polybasic acid such as phthalic acid or dimeric acid, linear aliphatic epoxy resins, alicyclic epoxy resins, heterocyclic epoxy resins, alkyl-modified polyfunctional epoxy resins, β-naphthol novolac-type epoxy resins, 1,6-dihydroxynaphthalene-type epoxy resins, 2,7-dihydroxynaphthalene-type epoxy resins, bis-hydroxybiphenyl-type epoxy resins, and furthermore, epoxy resins or the like in which a halogen such as bromine has been introduced in order to provide flame retardance.

The resin preferably includes one or more epoxy resins selected from the above, and more preferably contains an epoxy resin that is liquid at standard temperature. In particular, the resin preferably includes, among the above, one or more epoxy resins selected from among alicyclic epoxy resins and bisphenol-type epoxy resins such as bisphenol A-type epoxy resin or bisphenol F-type epoxy resin.

The resin content in the resin composition should preferably be 1-10 mass%, more preferably 2-9 mass%, even more preferably 3-8 mass%, and particularly preferably 4-6 mass%.

### (Curing agent)

In the case in which the resin composition includes an epoxy resin, a curing agent is preferably further included. As curing agents, there are, for example, novolac-type resins obtained by reacting one compound or a mixture of two or more compounds selected from the group consisting of phenol, cresol, xylenol, resorcinol, chlorophenol, t-butylphenol, nonylphenol, isopropylphenol, octylphenol, etc. with formaldehyde, paraformaldehyde, or paraxylene in the presence of an oxidation catalyst; polyparahydroxystyrene resins; bisphenol compounds such as bisphenol A and bisphenol S; trifunctional phenols such as pyrogallol and phloroglucinol; acid anhydrides such as maleic anhydride, phthalic anhydride, and pyromellitic anhydride; aromatic amines such as meta-phenylene diamine, diaminodiphenyl methane, diaminodiphenyl sulfone, etc.

The curing agent content should preferably be blended such that the hydroxyl equivalent amount (or acid anhydride equivalent amount) of the curing agent, relative to an epoxy equivalent amount 1 of the epoxy resin, becomes 0.5-1.25.

### (Other additives)

Curing promoters, mold release agents, coupling agents, coloring agents, etc. can also be blended into the resin composition within a range not compromising the effects of the present invention.

The curing promoters are not particularly limited, and examples include 1,8-diazobicyclo(5,4,0)undecene-7, triphenylphosphine, benzyldimethylamine, 2-methylimidazole, etc.

The mold release agents include natural waxes, synthetic waxes, metal salts of linear fatty acids, acid amides, esters, paraffins, etc.

The coupling agents include silane coupling agents. Silane coupling agents include epoxysilanes such as γ-glycidoxypropyltrimethoxysilane and β-(3,4-epoxycyclohexyl)ethyltrimethoxysilane; aminosilanes such as aminopropyl triethoxysilane, ureidopropyl triethoxysilane, and N-phenylaminopropyl trimethoxysilane; hydrophobic silane compounds such as phenyl trimethoxysilane, methyl trimethoxysilane, and octadecyl trimethoxysilane; mercaptosilanes, etc.

### (Production method)

The production method of the resin composition is not particularly limited, and the resin composition can be produced by stirring, dissolving, mixing, and dispersing prescribed amounts of the respective materials. The apparatuses for mixing, stirring, dispersing, etc. these mixtures are not particularly limited, and apparatuses such as grinding machines provided with stirring and heating apparatuses, three-roller milling machines, ball mills, and planetary mixers can be used. Additionally, these apparatuses may be used by being combined, as appropriate.

### (Use)

The resin composition according to the present embodiment can be used to produce a semiconductor encapsulating material. In particular, the resin composition can be favorably used as a semiconductor encapsulating material (liquid encapsulation material) for electronic devices since the flowability is excellent and the inorganic powder does not easily aggregate.

### EXAMPLES

The present invention will be more specifically explained by indicating examples below. However, these examples should not be construed as limiting the present invention.

### [Production Example 1]

An apparatus constituted by a vertical furnace having a burner installed on a furnace top portion and a collection system (cyclone and bag filter) was used to supply a silica raw material powder (volume-based cumulative 50% diameter D₅₀: 4.8 µm) obtained by pulverizing and classifying natural silica stone with 90% or higher purity to a high-temperature flame formed by combustion of LPG and oxygen, thereby performing a melting and sphere-forming treatment to obtain a spherical amorphous silica powder. This powder was classified by using sieve classification and an air classifier to obtain a spherical amorphous silica powder having volume-based cumulative diameters and local maximum values at peaks in the particle size frequency distribution as indicated in Table 1. At this time, the powder collection temperature was set to 230 °C.

### [Production Examples 2-5]

Spherical amorphous silica powders were obtained by the same method as Example 1, except that the powder collection temperatures were set as indicated in Table 1.

[Comparative Production Examples 1, 3-5, 7, and 8] Spherical amorphous silica powders were obtained by the same method as Example 1, except that the flame temperatures and the powder collection temperatures were set as indicated in Table 1.

### [Comparative Production Example 2]

A powder was produced in the same manner as Production Example 1, except that a silica raw material powder (volume-based cumulative 50% diameter D₅₀: 3.0 µm) was used and the powder collection temperature was set as indicated in Table 1.

### [Comparative Production Example 6]

A silica powder (mixed powder) was obtained by mixing a silica powder having a volume-based cumulative 50% diameter D₅₀ of 1.0 µm with a silica powder having a volume-based cumulative 50% diameter D₅₀ of 0.1 µm at a mass ratio of 8:2 by using a vertical mixer.

### [Measurement]

### (Volume-based cumulative diameter)

The cumulative particle size distributions of the silica powders of Production Examples 1-5 and Comparative Production Examples 1-9 were measured by a laser diffraction/scattering method (refractive index: 1.50) using a laser diffraction/scattering-type particle size distribution measuring apparatus ("LS-230" manufactured by Beckman-Coulter Inc.), with water (refractive index: 1.33) as the solvent, and by performing a dispersion treatment by using an "Ultrasonic Disruptor UD-200 (equipped with an ultramicrotip TP-040)" manufactured by Tomy Seiko Co., Ltd. to apply a 200 W output for two minutes as a pretreatment, to determine the volume-based cumulative 10% diameter D₁₀, the volume-based cumulative 25% diameter D₂₅, the volume-based cumulative 50% diameter D₅₀, the volume-based cumulative 90% diameter D₉₀, and the volume-based cumulative 100% diameter D₁₀₀. The cumulative frequency of the first peak and the cumulative frequency of the second peak were also determined.

The results are indicated in Table 1.

### (Particle size frequency distribution)

The volume-based particle size frequency distributions of the silica powders of Production Examples 1-5 and Comparative Production Examples 1-9 were measured by a laser diffraction/scattering method (refractive index: 1.50) using a laser diffraction/scattering-type particle size distribution measuring apparatus ("LS-230" manufactured by Beckman-Coulter Inc.), with water (refractive index: 1.33) as the solvent, and by performing a dispersion treatment by using an "Ultrasonic Disruptor UD-200 (equipped with an ultramicrotip TP-040)" manufactured by Tomy Seiko Co., Ltd. to apply a 200 W output for two minutes as a pretreatment. The local maximum values, the frequencies at the local maximum values, the local minimum values, and the frequencies at the local minimum values were determined. The values of the ratios of the frequency at the local maximum value of the second peak to the frequency at the local maximum value of the first peak, the ratios of the frequency at the local minimum value to the frequency at the local maximum value of the first peak, and the ratios of the cumulative frequency of the second peak to the cumulative frequency of the first peak were calculated. The results are indicated in Table 1.

The spherical amorphous silica powders of Production Examples 1-5 have two peaks with local maximum values in the range of particle diameters that are 3.0 µm or smaller. The two peaks are constituted by a peak (first peak) having a local maximum value in the vicinity of the 0.1-0.5 µm region and a peak (second peak) having a local maximum value in the vicinity of the 2.0-3.0 µm region. The first peak and the second peak are adjacent to each other and neither has a shoulder. The frequency at the local maximum value of the second peak is higher than the value of the frequency at the local maximum value of the first peak. The spherical amorphous silica powders of Production Examples 1-5 do not have local maximum values in the region in which the particle diameter exceeds 3.0 µm and do not have a particle size frequency distribution in the region in which the particle diameter is 7.0 µm or larger.

Between the first peak and the second peak, there is a boundary (local minimum value) at which the slope of the curve changes from negative to positive in the vicinity of the 0.5-1 µm region. Specifically, the spherical amorphous silica powder of Production Example 1 has a local minimum value at a particle diameter of 0.7 µm and a frequency of 0.4%. The spherical amorphous silica powder of Production Example 2 has a local minimum value at a particle diameter of 0.8 µm and a frequency of 1.6%. The spherical amorphous silica powder of Production Example 3 has a local minimum value at a particle diameter of 0.6 µm and a frequency of 1.7%. The spherical amorphous silica powder of Production Example 4 has a local minimum value at a particle diameter of 0.7 µm and a frequency of 0%.

### (Measurement of impurities)

The contents of Al₂O₃, Fe₂O₃, CaO, Na₂O, MgO, and K₂O were measured by the method below.

The samples were weighed out to 1.0 g on platinum dishes, 20 mL of hydrogen fluoride and 1 mL of perchloric acid were added and the samples were heated on sand baths to dissolve the samples, and the samples were concentrated until white smoke from the perchloric acid was generated. After allowing the samples to cool to room temperature, they were transferred to a 25 mL volumetric flask, and diluted to a marker line to respectively form test solutions for analysis. Separately from these, test solutions for dummy tests were obtained by performing all of the aforementioned operations without the samples. Thereafter, the respective contents were measured by ICP emission spectroscopy.

**[Table 1]**

| CATEGORY | PROD . EX.1 | PROD . EX.2 | PROD . EX.3 | PROD EX.4 | PROD EX.5 | COMP. PROD. EX.1 | COMP. PROD. EX.2 | COMP. PROD. EX.3 | COMP. PROD. EX.4 | COMP. PROD. EX.5 | COMP. PROD. EX.6 | COMP. PROD. EX.7 | COMP. PROD. EX.8 |
|---|---|---|---|---|---|---|---|---|---|---|---|---|---|
| FLAME TEMPERATURE (°C) | 2000 | 2000 | 2000 | 2000 | 2000 | 2500 | 2000 | 2200 | 2200 | 2600 | - | 2000 | 2300 |
| POWDER COLLECTION TEMPERATURE (°C) | 230 | 150 | 170 | 250 | 200 | 200 | 250 | 300 | 300 | 100 | - | 300 | 320 |
| SPECIFIC SURFACE AREA (BET METHOD) (m2/g) | 18 | 24 | 22 | 15 | 20 | 27 | 16 | 5.6 | 5.9 | 32 | 11.2 | 4.1 | 3.7 |
| D10 (µm) | 0.2 | 0.2 | 0.3 | 0.3 | 0.3 | 0.4 | 0.2 | 0.1 | 0.3 | 0.1 | 0.3 | 0.3 | 2.3 |
| D25 (µm) | 0.4 | 0.4 | 0.6 | 1.7 | 0.7 | 0.6 | 0.3 | 0.1 | 0.5 | 0.1 | 0.5 | 2.1 | 2.7 |
| D50 (µm) | 1.9 | 1.4 | 1.5 | 2.5 | 1.6 | 1.0 | 0.8 | 0.1 | 0.8 | 0.1 | 0.8 | 3.0 | 3.2 |
| D90 (µm) | 3.7 | 3.3 | 3.1 | 4.3 | 3.4 | 2.3 | 2.9 | 0.3 | 2.0 | 0.3 | 2.0 | 4.8 | 4.4 |
| D100 (µm) | 7.4 | 6.8 | 6.8 | 8.1 | 6.8 | 6.8 | 19.8 | 3.2 | 5.6 | 3.2 | 6.8 | 8.9 | 6.2 |
| LOCAL MAXIMUM VALUE (µm) OF FIRST PEAK | 0.3 | 0.3 | 0.4 | 0.2 | 0.4 | 0.3 | 0.2 | 1.3 | 0.3 | 0.1 | 1.0 | 0.2 | 3.2 |
| LOCAL MAXIMUM VALUE (µm) OF SECOND PEAK | 2.4 | 2.2 | 2.0 | 2.7 | 2.2 | 2.0 | - | - | 1.4 | - | - | 3.2 | - |
| FREQUENCY (%) AT LOCAL MAXIMUM VALUE OF FIRST PEAK | 1.7 | 2.5 | 1.9 | 0.9 | 1.6 | 6.4 | 5.4 | 5.2 | 2.9 | 6.7 | 4.5 | 0.9 | 13.5 |
| FREQUENCY (%) AT LOCAL MAXIMUM VALUE OF SECOND PEAK | 6.2 | 4.8 | 5.5 | 7.6 | 5.6 | 2.1 | - | - | 3.2 | - | - | 9.0 | - |
| SECOND PEAK/FIRST PEAK (VALUE OF RATIO BETWEEN FREQUENCIES AT LOCAL MAXIMUM VALUES) | 3.7 | 1.9 | 2.9 | 8.4 | 3.5 | 0.3 | - | - | 1.1 | - | - | 10.0 | - |
| LOCAL MINIMUM VALUE (µm) | 0.7 | 0.8 | 0.6 | 0.7 | 0.6 | 1.0 | - | - | 0.7 | - | - | 0.9 | - |
| FREQUENCY (%) AT LOCAL MINIMUM VALUE | 0.4 | 1.6 | 1.7 | 0.0 | 1.4 | 0.0 | - | - | 2.6 | - | - | 0.0 | - |
| LOCAL MINIMUM VALUE/FIRST PEAK LOCAL MAXIMUM VALUE (VALUE OF RATIO BETWEEN FREQUENCIES) | 0.2 | 0.6 | 0.9 | 0.0 | 0.9 | 0.0 | - | - | 0.9 | - | - | 0.0 | - |
| CUMULATIVE FREQUENCY (%) OF FIRST PEAK | 28.1 | 39.9 | 26.9 | 14.0 | 24.6 | 80.9 | 100.0 | 100.0 | 56.9 | 100.0 | 100.0 | 14.2 | 100.0 |
| CUMULATIVE FREQUENCY (%) OF SECOND PEAK | 71.9 | 60.1 | 73.1 | 86.0 | 75.4 | 19.1 | 0.0 | 0.0 | 43.1 | 0.0 | 0.0 | 85.8 | 0.0 |
| SECOND PEAK/FIRST PEAK (VALUE OF RATIO BETWEEN CUMULATIVE FREQUENCIES) | 2.6 | 1.5 | 2.7 | 6.1 | 3.1 | 0.2 | 0.0 | 0.0 | 0.8 | 0.0 | 0.0 | 6.0 | 0.0 |
| CUMULATIVE FREQUENCY (%) OF PARTICLES WITH PARTICLE SIZE EQUAL TO OR LARGER THAN 5.0 µm | 1.0 | 0.4 | 0.1 | 3.4 | 0.3 | 0.2 | 1.5 | 0.1 | 1.6 | 0.0 | 0.2 | 6.5 | 1.5 |
| Al₂O₃ (ppm) | 460 | 510 | 680 | 550 | 640 | 1730 | 2400 | 2000 | 300 | 180 | 1850 | 260 | 2380 |
| Fe₂O₃ (ppm) | 14 | 13 | 35 | 21 | 32 | 100 | 40 | 100 | 86 | 52 | 110 | 18 | 37 |
| CaO (ppm) | 10 | 12 | 10 | 15 | 16 | 19 | 20 | 25 | 14 | 6 | 25 | 43 | 17 |
| Na₂O (ppm) | 30 | 23 | 16 | 32 | 36 | 58 | 40 | 50 | 1 | 1 | 62 | 11 | 33 |
| MgO (ppm) | 13 | 12 | 12 | 10 | 8 | 15 | 16 | 15 | 3 | 2 | 15 | 5 | 12 |
| K₂O (ppm) | 19 | 9 | 9 | 15 | 17 | 98 | 60 | 18 | 1 | 2 | 88 | 11 | 48 |

### [Examples 1-11 and Comparative Examples 1-10]

In order to evaluate the properties of resin compositions including the silica powders of Production Examples 1-5 and Comparative Examples 1-8, resin compositions were produced by using the materials below.
Resin: Biphenyl-type epoxy resin ("YH-4000HK", manufactured by Mitsubishi Chemical Corp.)
Curing agent: Phenol resin (manufactured by Meiwa Plastic Industries, Ltd.)
Curing promoter: Triphenylphosphine
Mold release agent
Silane coupling agent: Epoxy silane ("KBM-403" manufactured by Shin-etsu Chemical Co., Ltd.)

The resin compositions were produced in the manner indicated below. The silica powders of Examples 1-5 and Comparative Examples 1-13 were mixed together with the above-mentioned materials, with the components and proportions described in Table 2, for 10 minutes using a rotation-revolution-type planetary mixer (Awatori Rentaro AR-360M, manufactured by Thinky Corp.) under conditions with rotation at 2000 rpm and revolution at 600 rpm, then vacuum-defoamed to obtain resin compositions.

The flowability of the obtained resin compositions and the aggregation states of the silica powders in the resin compositions were measured and evaluated by the methods indicated below. The results are indicated in Table 2.

### (Flowability evaluation)

The spiral flow values of the respective resin compositions were measured using a transfer molding machine equipped with a spiral flow-measuring mold compliant with EMMI-I-66 (Epoxy Molding Material Institute; Society of Plastic Industry).

The transfer molding conditions were set such that the die temperature was 175 °C, the molding pressure was 7.4 MPa and the retention time was 120 seconds.

The higher this value is (preferably 115 cm or higher), the better the flowability is.

### (Evaluation of aggregation state: Measurement of content of aggregates with mesh size of 75 µm or larger)

The silica was weighed out to 100 g and loaded into a sieve with a mesh size of 75 µm. The silica was sieved by being sprayed for 30 seconds with 1000 mL of purified water from a shower-type nozzle. The silica remaining on the sieve was recovered in an evaporation dish and dried with a dryer, then weighed to compute the percentage of residue. In the case of a "○", aggregation in the resin composition was able to be suppressed.

The evaluations were performed under the standards below.
○ (pass): 0.0%-2.0%
△ (fail): 2.0%-10%
× (fail): 10%-100%

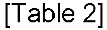

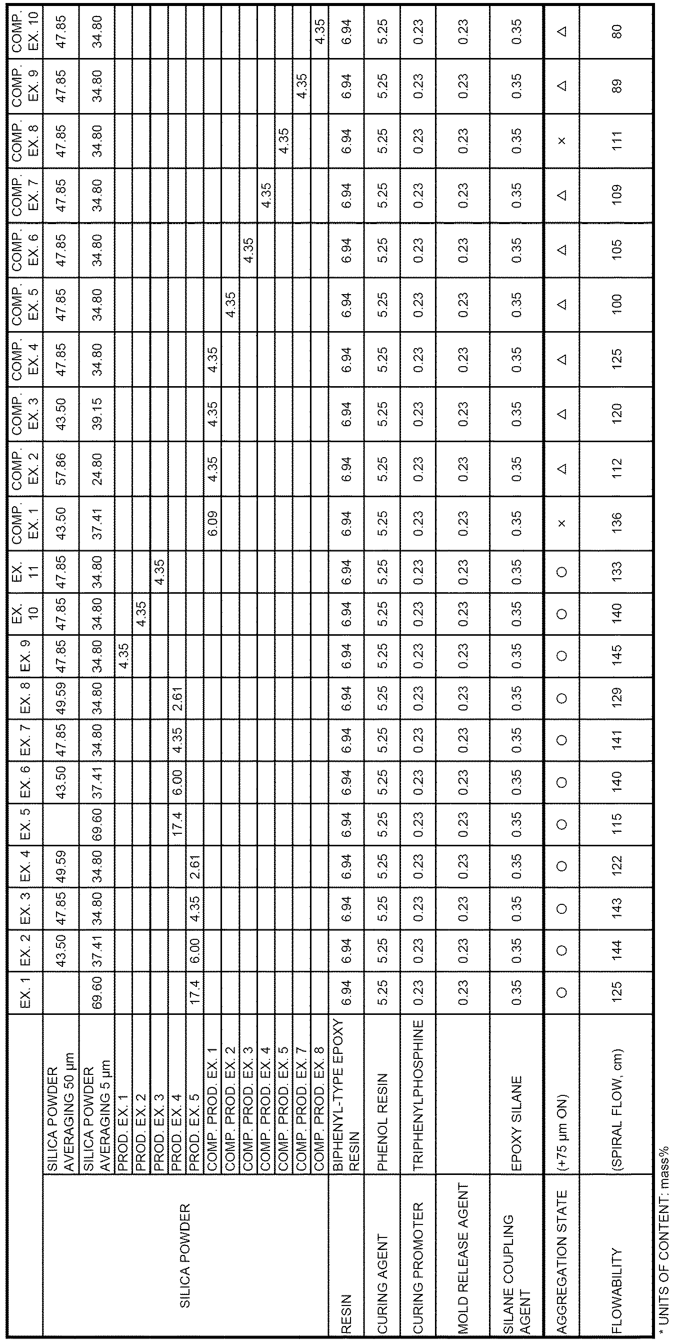

## Claims

1. A spherical inorganic powder having, in a particle size frequency distribution, a first peak having a local maximum value in a particle size region from 0.1 µm or larger to 0.6 µm or smaller, and a second peak having a local maximum value in a particle size region from 1.5 µm or larger to 5.0 µm or smaller, wherein a value of a ratio of a frequency at the local maximum value of the second peak to a frequency at the local maximum value of the first peak is 1.5 or higher and lower than 10.0.

2. The spherical inorganic powder according to claim 1 having, in the particle size frequency distribution, a local minimum value in a particle size region from 0.4 µm or larger to 1.0 µm or smaller.

3. The spherical inorganic powder according to claim 2, wherein the ratio of the frequency at the local minimum value to the frequency at the local maximum value of the first peak is 0.9 or lower.

4. The spherical inorganic powder according to any one of claims 1 to 3, wherein a ratio of a cumulative frequency of the second peak to a cumulative frequency of the first peak is 1.2 or higher.

5. The spherical inorganic powder according to any one of claims 1 to 4 wherein, in the particle size frequency distribution, the cumulative frequency of particles having a particle diameter of 5.0 µm or larger is 1.2% or lower.

6. The spherical inorganic powder according to any one of claims 1 to 5, wherein the spherical inorganic powder is silica, and a content of each of at least one component selected from the group consisting of iron oxide, sodium oxide, calcium oxide, magnesium oxide, and potassium oxide is 50 ppm or less.

7. The spherical inorganic powder according to any one of claims 1 to 5, wherein the spherical inorganic powder is silica and the alumina content is 200 ppm or more and 1300 ppm or less.

8. A liquid encapsulation material containing a resin and the spherical inorganic powder according to any one of claims 1 to 7.
